Europäisches Patentamt

European Patent Office

Office européen des brevets

(19)

(11) **EP 1 431 729 A1**

(12) **EUROPÄISCHE PATENTANMELDUNG**

(43) Veröffentlichungstag:
    **23.06.2004 Patentblatt 2004/26**

(51) Int Cl.⁷: **G01H 9/00**, B23K 20/00,
    B23K 20/10

(21) Anmeldenummer: **02102871.7**

(22) Anmeldetag: **20.12.2002**

(84) Benannte Vertragsstaaten:
    **AT BE BG CH CY CZ DE DK EE ES FI FR GB GR
    IE IT LI LU MC NL PT SE SI SK TR**
    Benannte Erstreckungsstaaten:
    **AL LT LV MK RO**

(71) Anmelder: **Esec Trading S.A.**
    **6330 Cham (CH)**

(72) Erfinder: **MELZER, Martin**
    **6312, Steinhausen (CH)**

(74) Vertreter: **Falk, Urs, Dr. et al**
    **Patentanwaltsbüro Dr. Urs Falk,
    Eichholzweg 9A
    6312 Steinhausen (CH)**

(54) **Einrichtung zur Messung der Schwingungsamplitude der Spitze einer Kapillare**

(57)    Eine Einrichtung zur Messung der Schwingungsamplitude der Spitze einer Kapillare (1) mittels eines Lichtstrahls (6) umfasst eine Lichtquelle (5) und einen Lichtempfänger (11) und zwei Lochblenden (8, 10), die zwischen der Lichtquelle (5) und dem Lichtempfänger (11) angeordnet sind und die auf einer gemeinsamen Achse (19) liegen. Die Lochblenden (8, 10) sind bevorzugt durch in Seitenwänden (15, 16) eines in einem Körper (13) gebildeten Kanals (14) auf einer gemeinsamen Achse (19) angeordnete Bohrungen (17, 18) gebildet. Die beiden Lochblenden (8, 10) definieren den Durchmesser des Lichtstrahls (6).

Fig. 2

EP 1 431 729 A1

**Beschreibung**

Die Erfindung betrifft eine Einrichtung für die Messung der Amplitude einer frei schwingenden Kapillare eines Wire Bonders der im Oberbegriff des Anspruchs 1 genannten Art.

Ein Wire Bonder ist eine Maschine, mit der Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Bei der Herstellung der Drahtverbindung zwischen dem Anschlusspunkt des Halbleiterchips und dem Anschlusspunkt des Substrates wird das aus der Kapillare ragende Drahtende zunächst zu einer Kugel geschmolzen. Anschliessend wird die Drahtkugel auf dem Anschlusspunkt des Halbleiterchips mittels Druck und Ultraschall befestigt. Dabei wird das Horn von einem Ultraschallgeber mit Ultraschall beaufschlagt. Diesen Prozess nennt man Ball-bonden. Dann wird der Draht auf die benötigte Drahtlänge durchgezogen, zu einer Drahtbrücke geformt und auf dem Anschlusspunkt des Substrates verschweisst. Diesen letzten Prozessteil nennt man Wedge-bonden. Nach dem Befestigen des Drahtes auf dem Anschlusspunkt des Substrats wird der Draht abgerissen und der nächste Bondzyklus kann beginnen.

Aus dem europäischen Patent EP 498 936 B1 sind ein Verfahren und eine Einrichtung bekannt, um die Amplitude der frei schwingenden Kapillare zu messen. Der Messwert wird benützt für die Kalibrierung des Ultraschallgebers. Die Messung der Schwingungsamplitude der Kapillare erfolgt mittels einer Lichtschranke.

Aus der japanischen Patentanmeldung 10-209 199 sind ein Verfahren und eine Einrichtung bekannt, um die Amplitude der frei schwingenden Kapillare zu messen, bei denen für die Lichtschranke ein Laserstrahl benutzt wird.

Versuche haben gezeigt, dass die Messung mit der bekannten Technik keine reproduzierbaren Resultate liefert, wenn die Amplitude der Spitze der frei schwingenden Kapillare gemessen werden soll.

Der Erfindung liegt die Aufgabe zugrunde, eine Einrichtung für die Messung der Amplitude der Spitze einer frei schwingenden Kapillare zu entwickeln.

Die genannte Aufgabe wird erfindungsgemäss gelöst durch die Merkmale des Anspruchs 1.

Die Erfindung geht aus von einem Verfahren und einer Einrichtung für die Messung der Amplitude der Spitze einer frei schwindenden Kapillare, die von der Anmelderin als europäische Patentanmeldung Nr. 02004700.7 eingereicht wurde, die aber noch nicht veröffentlicht ist. Das in dieser Patentanmeldung beschriebene Verfahren basiert auf der Abschattung des Lichtstrahls durch die Kapillare, wobei die Schwingungen der Kapillare die Intensität des durchgelassenen Lichtstrahls modulieren. Die Intensität des durchgelassenen Lichtstrahls wird mittels eines Lichtempfängers gemessen. Die Schwingungsrichtung der Kapillare in der Ebene ist in der Regel nicht bekannt. Es ist in der Regel aber so, dass die Schwingungen der Kapillare hauptsächlich in Richtung der Längsachse des Horns verlaufen. Mit dem Messprinzip der Abschattung eines Lichtstrahles kann nur die Komponente der Amplitude der Schwingungen der Kapillare gemessen werden, die senkrecht zur Richtung des Lichtstrahles verläuft. Die Messeinrichtung umfasst eine Lichtquelle zur Erzeugung eines Lichtstrahls mit einem in einem Arbeitsbereich der Einrichtung gut definierten Durchmesser. Der wirksame Durchmesser des Lichtstrahls in der Messebene ist kleiner als der Durchmesser der Kapillare an der zu messenden Stelle.

Es gibt leider eine Vielzahl von unerwünschten Effekten wie z.B. Verschmutzungen der Kapillare, Beugung an der Kapillare, graduelle Oberflächenvariationen der Kapillare, Asymmetrien des Lichtstrahls, usw., die eine reproduzierbare Messung erschweren, wenn nicht besondere Massnahmen getroffen werden. Gemäss dem in der oben zitierten Patentanmeldung beschriebenen Verfahren wird eine Vielzahl von Messungen durchgeführt und die erhaltenen Messwerte werden gemittelt. In einem ersten Schritt wird die Kapillare bezüglich des Lichtstrahls justiert. Anschliessend wird die Komponente $A_y$ der Schwingungen der Kapillare, die senkrecht zur Richtung des Lichtstrahls verläuft, gemäss den folgenden Schritten ermittelt:

a) Plazieren der Kapillare auf der einen Seite des Lichtstrahls, ohne dass sie den Lichtstrahl abschattet, und Beaufschlagen des Horns mit Ultraschall;
b) Bewegung der Kapillare in einer vorgegebenen Anzahl von n Schritten entlang einer vorbestimmten Richtung w in den Lichtstrahl hinein oder vollständig durch den Lichtstrahl hindurch, bis sie sich auf der anderen Seite des Lichtstrahls befindet, wobei bei jedem der $i = 1$ bis n Schritte der Gleichspannungsanteil $U_{DC}(y_i)$ und der Wechselspannungsanteil $U_{AC}(y_i)$ des Ausgangssignals $U_P(y_i)$ des Lichtempfängers sowie eine Koordinate $y_i$ ermittelt werden, wobei die Koordinate $y_i$ die Position der Kapillare in Bezug auf eine senkrecht zum Lichtstrahl verlaufende Koordinatenachse y bezeichnet und wobei die zu messende Komponente $A_y$ in Richtung der Koordinatenachse y verläuft;
c) Berechnung von Empfindlichkeitswerten $S_i(y_i)$ als Ableitung des Gleichspannungsanteils $U_{DC}(y_i)$ nach der Koordinatenachse y zu $S_i(y_i) = \dfrac{dU_{DC}(y_i)}{dy}$;
d) Auswahl von wenigstens vier Messpunkten und für jeden dieser mindestens vier Messpunkte Berechnung eines Wertes $A_{y,i}$ zu $A_{y,i} = \dfrac{U_{AC}(y_i)}{S_i(y_i)}$;

e) Berechnung der Komponente $A_y$ als Mittelwert aus den Werten $A_{y,i}$.

Vorteilhaft erfolgt die Berechnung der Komponente $A_y$ unter Anwendung statistischer Methoden. Insbesondere ist es von Vorteil, die im Schritt c berechneten Empfindlichkeitswerte $S_i(y_i)$ noch zu glätten, beispielsweise durch Mittelung mit benachbarten Messpunkten. Vorteilhaft ist es auch, die Messwerte $U_{DC}(y_i)$ und $U_{AC}(y_i)$ zu glätten. Vorteilhaft ist es weiter, nicht nur vier Messpunkte, sondern möglichst viele Messpunkte zu berücksichtigen. Ein mögliches Kriterium für die Auswahl der Messpunkte ist z.B., dass die Empfindlichkeit $S_i$ einen vorbestimmten Minimalwert überschreitet.

Die vorliegende Erfindung besteht darin, für die Erzeugung des Lichtstrahls zwei koaxial angeordnete Lochblenden zu verwenden, die zwischen dem Lichtsender und dem Lichtempfänger angeordnet sind. Die erfindungsgemässe Messeinrichtung umfasst daher im einfachsten Fall nur noch drei Komponenten, nämlich den Lichtsender, einen Körper mit einem Kanal, dessen beide Seitenwände je eine Bohrung enthalten, die auf einer gemeinsamen Achse liegen, und den Lichtempfänger. Diese Achse verläuft transversal zur Längsachse des Kanals. Vom Lichtsender ausgestrahltes Licht gelangt durch die eine Bohrung in den Kanal und durch die zweite Bohrung hindurch auf den Lichtempfänger. Die beiden mit den Bohrungen versehenen Seitenwände des Kanals bilden die beiden koaxial angeordneten Lochblenden. Für die Messung der Schwingungsamplitude der Kapillare wird die Kapillare in Längsrichtung des Kanals gemäss dem oben beschriebenen Verfahren durch den durch die beiden Lochblenden definierten Lichtstrahl hindurch bewegt. Als Lichtsender kann eine herkömmliche Leuchtdiode oder eine Laserdiode verwendet werden. Die Seitenwände des Kanals verlaufen im Bereich der Bohrungen parallel zueinander und sind dann nach oben aufgeweitet, damit einerseits der Abstand zwischen dem Lichtsender und dem Lichtempfänger möglichst klein ist und damit andererseits die Kapillare zwischen den Seitenwänden Platz hat und die Seitenwände nicht berührt. Das Ausgangssignal des Lichtempfängers wird von einer elektronischen Schaltung verstärkt. Da das Ausgangssignal des Lichtempfängers sehr schwach ist, ist es nötig, die elektronische Schaltung gegen elektrische Felder abzuschirmen, beispielsweise mittels eines Faraday Käfigs.

Bei einer alternativen Ausführungsform umfasst die Messeinrichtung eine weitere Komponente, nämlich einen zwischen der zweiten Bohrung und dem Lichtempfänger angeordneten Lichtleiter. Als Lichtleiter kann ein herkömmlicher Lichtleiter aus Kunststoff oder Glas verwendet werden. Diese Ausführungsform hat den Vorteil, dass die elektronische Schaltung nicht direkt bei der Messeinrichtung platziert werden muss.

Der Vorteil der Erfindung liegt darin, dass die Messeinrichtung kostengünstig herstellbar ist.

Nachfolgend werden Ausführungsbeispiele der Erfindung anhand der Zeichnung näher erläutert.

Es zeigen:

Fig. 1  eine Messeinrichtung zur Messung der Amplitude der Schwingungen der Spitze einer Kapillare,

Fig. 2  eine erste Ausführungsform der Messeinrichtung, und

Fig. 3  eine zweite Ausführungsform der Messeinrichtung.

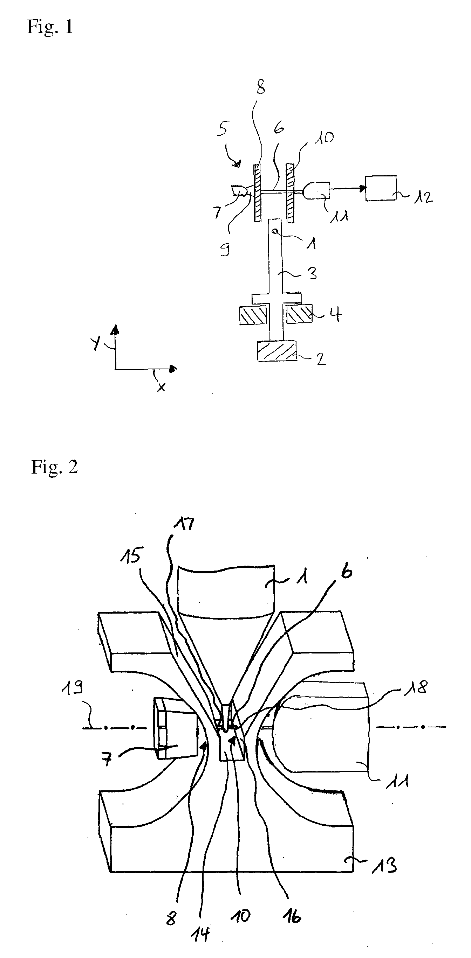

Die Fig. 1 zeigt schematisch und in Aufsicht eine Kapillare 1, die an der Spitze eines von einem Ultraschallgeber 2 mit Ultraschall beaufschlagbaren Horns 3 eingespannt ist, und eine Messeinrichtung zur Messung der Amplitude der Schwingungen der Spitze der Kapillare 1. Mit x, y und z sind die Koordinaten eines kartesischen Koordinatensystems bezeichnet, wobei die z-Koordinate senkrecht zur Zeichenebene verläuft. Das Horn 3 ist an einem Bondkopf 4 eines Wire Bonders befestigt. Der Bondkopf 4 ermöglicht die Bewegung der Spitze der Kapillare 1 in allen drei Koordinatenrichtungen. Die Messeinrichtung umfasst eine Lichtquelle 5 zur Erzeugung eines Lichtstrahls 6 mit einem definierten Durchmesser. Die Lichtquelle 5 besteht aus einer Leuchtdiode 7 und einer ersten Lochblende 8, die den von der Leuchtdiode 7 ausgesandten Lichtkegel 9 in den Lichtstrahl 6 transformiert. Die Einrichtung umfasst weiter eine zweite Lochblende 10 und einen Lichtempfänger 11. Die beiden Lochblenden 8 und 10 definieren die Achse für die Messung relevanten Durchmessers des Lichtstrahls 6. Der Durchmesser der Spitze der Kapillare 1 beträgt etwa 50 µm bis 150 µm. Der Durchmesser des Lichtstrahls 6 ist bevorzugt kleiner als der Durchmesser der Kapillare 1 an der zu messenden Stelle. Im Beispiel beträgt der Durchmesser der Lochblenden 8 und 10 und somit des Lichtstrahls 6 etwa 40 µm. Der Durchmesser des Lichtstrahls 6 kann aber auch so gross wie der Durchmesser der Kapillare 1 an der zu messenden Stelle oder etwas grösser sein, wobei dann allerdings im Verlauf der Messung keine vollständige Abschattung des Lichtstrahls 6 erfolgt. Das Ausgangssignal des Lichtempfängers 11 wird von einer elektronischen Schaltung 12 verstärkt. Die elektronische Schaltung 12 ist vorzugsweise in einem Gehäuse aus Metall untergebracht, um die elektronische Schaltung 12 gegenüber äusseren elektrischen Feldern abzuschirmen.

Wie aus der Fig. 1 ersichtlich ist, verläuft der Lichtstrahl 6 in x-Richtung. Die Längsachse 8 des Horns 3 verläuft in y-Richtung. Für eine Einzelmessung der Amplitude der Schwingungen der Spitze der Kapillare 1 wird die Spitze der Kapillare 1 im Prinzip so im Lichtstrahl 6 positioniert, dass sie einen Teil des Lichtstrahls 6 abschattet. Wenn der Ultraschallgeber 2 eingeschaltet ist, schwingt die Spitze der Kapillare 1 in der xy-Ebene. Die y-Komponente $A_y$ dieser Schwingungen bewirkt eine Änderung der Abschattung des Lichtstrahls 6, welche vom Lichtempfänger 11 detektiert wird, während die

x-Komponente $A_x$ dieser Schwingungen die Abschattung nicht ändert. Bevorzugt wird aber nicht eine Einzelmessung durchgeführt, sondern es wird das oben beschriebene Verfahren angewandt, bei dem die mit Ultraschall beaufschlagte Kapillare 1 von der einen Seite durch den Lichtstrahl 6 hindurch auf die andere Seite bewegt wird.

Die Fig. 2 zeigt in perspektivischer Ansicht ein erstes Ausführungsbeispiel der Messeinrichtung. Die Messeeinrichtung umfasst den Lichtsender, einen Körper 13 mit einem Kanal 14, dessen beide Seitenwände 15 und 16 je eine Bohrung 17 bzw. 18 enthalten, die auf einer gemeinsamen Achse 19 liegen, und den Lichtempfänger 11. Diese 19 Achse verläuft transversal zur Längsachse des Kanals 14. Als Lichtsender dient eine herkömmliche Leuchtdiode oder Laserdiode 7. Von der Leuchtdiode 7 ausgestrahltes Licht gelangt durch die eine Bohrung 17 in den Kanal 14 und durch die zweite Bohrung 18 hindurch auf den Lichtempfänger 11. Die beiden mit der Bohrung 17 bzw. 18 versehenen Seitenwände 15 und 16 des Kanals 14 bilden die beiden koaxial angeordneten Lochblenden 8 und 10. Für die Messung der Schwingungsamplitude der Kapillare 1 wird die Kapillare 1 in Längsrichtung 20 des Kanals 14 gemäss dem oben beschriebenen Verfahren durch den durch die beiden Lochblenden 8 und 10 definierten Lichtstrahl 6 hindurch bewegt. Die Seitenwände 15 und 16 des Kanals 14 verlaufen im Bereich der Bohrungen 17 und 18 parallel zueinander und sind dann nach oben aufgeweitet, damit einerseits der Abstand zwischen der Leuchtdiode 7 und dem Lichtempfänger 11 möglichst klein ist und damit andererseits die Kapillare 1 zwischen den Seitenwänden 15 und 16 Platz hat und die Seitenwände 15 und 16 nicht berührt.

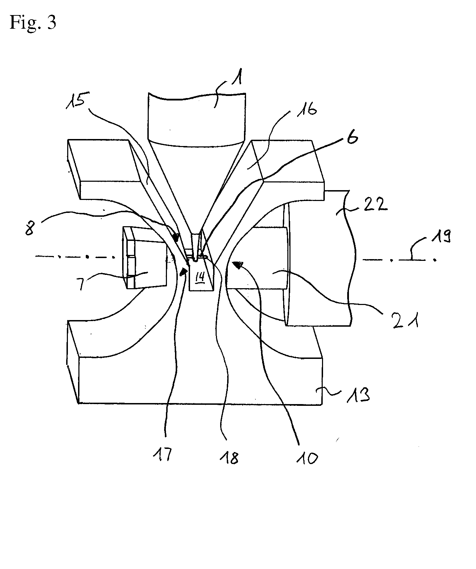

Die Fig. 3 zeigt in perspektivischer Ansicht ein zweites Ausführungsbeispiel der Messeinrichtung. Das zweite Ausführungsbeispiel entspricht weitgehend dem ersten Ausführungsbeispiel, aber mit dem Unterschied, dass zwischen der zweiten Lochblende 10 und dem Lichtempfänger 11 ein Lichtleiter 21 angeordnet ist. Der Lichtleiter 21 besteht aus dem lichtleitenden Kern und einem Mantel 22. Dieses Ausführungsbeispiel bietet den Vorteil, dass die elektronische Schaltung 12 (Fig. 2) an einem geeigneten Ort im Wire Bonder platziert werden kann, wo zudem ihre elektrische Abschirmung problemlos möglich ist.

Bei allen Ausführungsbeispielen ist der Durchmesser D der in den Seitenwänden 15 und 16 angebrachten koaxialen Bohrungen 17 und 18, und somit der Lochblenden 8 und 10, vergleichbar dem Durchmesser der Spitze der Kapillare 1, damit der Lichtstrahl 6 im Verlaufe der Messung möglichst vollständig abgedeckt wird. Der Durchmesser D ist also typischerweise kleiner als 150 μm. Der Durchmesser D beträgt beispielsweise 100 μm, er kann aber auch für eine extrem dünne Kapillare 1 nur noch 40 μm betragen.

Die erfindungsgemässe Messeinrichtung kann entweder fest auf dem Wire Bonder installiert sein oder als selbstständige Messeinrichtung ausgebildet sein, die für eine Messung der Schwingungsamplitude der Kapillare nur vorübergehend auf dem Wire Bonder installiert wird. Wenn die Schwingungsrichtung der Kapillare 1 nicht mit der Längsrichtung des Horns 3 (Fig. 1) zusammenfällt, dann kann die Amplitude der Schwingungen der Kapillare 1 durch zwei Messungen ermittelt werden, bei denen die Messeinrichtung um 90° zueinander verdreht ist. Es werden dann nacheinander die Komponente $A_x$ und die Komponente $A_y$ der Amplitude A der Schwingungen der Kapillare 1 bestimmt und daraus die Amplitude A berechnet.

**Patentansprüche**

1. Einrichtung zur Messung der Schwingungsamplitude der Spitze einer Kapillare (1), mit einer Lichtquelle (5) und einem Lichtempfänger (11), **dadurch gekennzeichnet, dass** zwischen der Lichtquelle (5) und dem Lichtempfänger (11) zwei Lochblenden (8, 10) vorhanden sind, die koaxial zueinander angeordnet sind.

2. Einrichtung nach Anspruch 1, **dadurch gekennzeichnet, dass** die Lochblenden (8, 10) durch in Seitenwänden (15, 16) eines in einem Körper (13) gebildeten Kanals (14) auf einer gemeinsamen Achse (19) angeordnete Bohrungen (17, 18) gebildet sind.

3. Einrichtung nach Anspruch 1 oder 2, **dadurch gekennzeichnet, dass** der Durchmesser der Lochblenden (8, 10) weniger als 100 μm beträgt.

Fig. 1

Fig. 2

Fig. 3

Europäisches Patentamt

**EUROPÄISCHER RECHERCHENBERICHT**

Nummer der Anmeldung

EP 02 10 2871

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X,D | EP 0 498 936 A (ESEC SA) 19. August 1992 (1992-08-19) | 1 | G01H9/00 B23K20/00 B23K20/10 |
| Y | * Spalte 3, Zeile 7-24; Abbildung 2 * | 2,3 | |
| X | FR 1 086 997 A (PERFECTIONNEMENT DES MATERIELS) 17. Februar 1955 (1955-02-17) | 1 | |
| Y | * Seite 2, Spalte 2, Zeile 21-34; Abbildung 3 * | 2,3 | |
| A,D | PATENT ABSTRACTS OF JAPAN vol. 1998, no. 13, 30. November 1998 (1998-11-30) -& JP 10 209199 A (TOSHIBA CORP), 7. August 1998 (1998-08-07) * Zusammenfassung; Abbildung 17 * | 1-3 | |
| A | PATENT ABSTRACTS OF JAPAN vol. 003, no. 052 (E-108), 7. Mai 1979 (1979-05-07) -& JP 54 030880 A (TOSHIBA CORP), 7. März 1979 (1979-03-07) * Zusammenfassung; Abbildungen * | 1 | |
| A | US 5 070 483 A (BERNI ALBERT J ET AL) 3. Dezember 1991 (1991-12-03) * Spalte 19, Zeile 19-22; Abbildung 7 * | 1 | |

**RECHERCHIERTE SACHGEBIETE (Int.Cl.7)**

G01H
B23K

Der vorliegende Recherchenbericht wurde für alle Patentansprüche erstellt

| Recherchenort | Abschlußdatum der Recherche | Prüfer |
|---|---|---|
| DEN HAAG | 23. Mai 2003 | Jaeger, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**EP 1 431 729 A1**

**ANHANG ZUM EUROPÄISCHEN RECHERCHENBERICHT**
**ÜBER DIE EUROPÄISCHE PATENTANMELDUNG NR.**  EP 02 10 2871

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-05-2003

| Im Recherchenbericht angeführtes Patentdokument | | | Datum der Veröffentlichung | Mitglied(er) der Patentfamilie | | Datum der Veröffentlichung |
|---|---|---|---|---|---|---|
| EP 0498936 | A | | 19-08-1992 | AT | 117611 T | 15-02-1995 |
| | | | | DE | 59104416 D1 | 09-03-1995 |
| | | | | EP | 0498936 A1 | 19-08-1992 |
| | | | | HK | 103495 A | 07-07-1995 |
| | | | | JP | 3178874 B2 | 25-06-2001 |
| | | | | JP | 4319627 A | 10-11-1992 |
| | | | | US | 5199630 A | 06-04-1993 |
| FR 1086997 | A | | 17-02-1955 | KEINE | | |
| JP 10209199 | A | | 07-08-1998 | KEINE | | |
| JP 54030880 | A | | 07-03-1979 | JP | 1225472 C | 31-08-1984 |
| | | | | JP | 58056094 B | 13-12-1983 |
| US 5070483 | A | | 03-12-1991 | GB | 2243968 A | 13-11-1991 |

EPO FORM P0461

Für nähere Einzelheiten zu diesem Anhang : siehe Amtsblatt des Europäischen Patentamts, Nr.12/82